# EUROPEAN PATENT APPLICATION

(11) **EP 0 971 422 A1**
(43) Date of publication of application: **12.01.2000**
(21) Application number: 99112795.2
(22) Date of filing: 02.07.1999
(51) Int. Cl.: H01L 39/22, H01L 39/24

(54) **Oxide superconducting element and material**

(30) Priority: 03.07.1998 JP 18920998
(71) Applicant: INTERNATIONAL SUPERCONDUCTIVITY TECHNOLOGY CENTER, Tokyo 105-0004 (JP)
(72) Inventor: Morishita, Tadataka, Intern. Supercond. Techn. Cen, Koto-ku, Tokyo (JP); Tanabe, Keiichi, Intern. Supercond. Techn. Center, Koto-ku, Tokyo (JP); Shiohara, Yuh, Intern. Supercond. Techn. Center, Koto-ku, Tokyo (JP); Enomoto, Youichi, Intern. Supercond. Techn. Center, Koto-ku, Tokyo (JP); Tanaka, Shoji, Intern. Supercond. Techn. Center, Koto-ku, Tokyo (JP)
(74) Representative: Beetz & Partner Patentanwälte

(57) **Abstract**

An element 11 serving also as a substrate is formed of an oxide superconducting single crystal or thick-film. A mechanical grinding process is performed to a surface (11a) of the element (11), thereby gaining an atomic size flatness. An interlayer insulation layer (12) is deposited on the surface (11a), and on top of the insulation layer (12) is formed an oxide superconducting layer (13) constituting a lower electrode, a barrier layer (14), and an oxide superconducting layer (15) constituting an upper electrode, thereby manufacturing an oxide superconducting element.

## Description

### BACKGROUND OF THE INVENTION

### 1. Field of the Invention

The present invention relates to forming an oxide superconducting element utilizing a single crystal or a thick-film of an oxide superconductor as a superconducting electrode or a ground plane.

### 2. Description of the Prior Art

When manufacturing an oxide superconducting element with a Josephson junction utilizing an oxide superconductor, a thin film is laminated on top of an insulating oxide substrate, and a three layer structure of an oxide superconductor (upper electrode) / ordinary conductor or insulator (barrier layer) / oxide superconductor (lower electrode) is formed. In an element equipped with a ground plane, an insulator / oxide superconductor (ground plane) must be added between the three layer film and the substrate. In such method, the surface unevenness of the oxide superconducting layer of the lower electrode or the ground plane affects the flatness of each layer to be deposited above the oxide superconductor. Especially, according to the conventional method, it was very difficult to secure the evenness of the barrier layer having a very small thickness of approximately 1 - 10 nm.

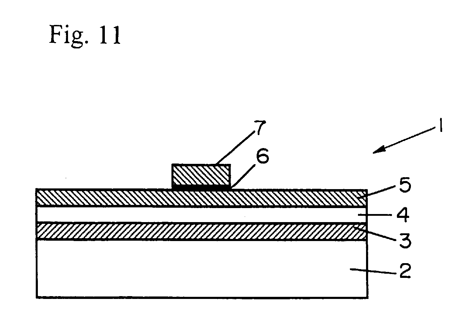

FIG. 11 is a typified diagram showing the structure of a conventional oxide superconducting element.

The oxide superconducting element 1 is formed by laminating on an insulating substrate 2 an oxide superconducting layer (ground plane) 3 and an interlayer insulation layer 4, and on the insulation layer is formed an oxide superconducting layer (lower electrode) 5 / barrier layer 6 / oxide superconducting layer (upper electrode) 7.

### SUMMARY OF THE INVENTION

In the conventional superconducting element explained above, it was necessary to utilize an insulating substrate having high rigidity, which enables to improve the surface flatness by mechanical processes, so as to secure the surface flatness of the ground plane or the lower electrode.

Therefore, the present invention provides a highly reliable superconducting element and a Josephson junction manufactured by forming a uniform laminated structure of high quality, wherein the surface of the oxide superconducting layer forming the lower superconducting electrode and the ground plane is flattened through a mechanical grinding process without vitiating the superconductivity thereof, and thereby enabling to omit the conventional insulating substrate.

In order to flatten the surface of the oxide superconducting layer by a mechanical grinding process, it is necessary to form an oxide superconductor having a sufficient thickness to bear the portion to be consumed by the grinding. A single crystal or a thick-film of an oxide superconductor manufactured by a liquid phase epitaxial method which fulfils the above requirement is applied in the present invention.

### BRIEF DESCRIPTION OF DRAWINGS

FIG. 1 is a typified drawing showing the structure of the oxide superconducting element according to the present invention;
FIG. 2 is a typified drawing showing the atomic force microscope image of the mechanically ground surface of the oxide superconducting single crystal;
FIG. 3 is a typified drawing showing the atomic force microscope image of the mechanically ground surface of the oxide superconducting thick-film;
FIG. 4 is a typified drawing showing the cross-sectional transmission electron microscope (TEM) image of the material where an insulator is laminated on a mechanically ground oxide superconducting single crystal surface so as to form a ground plane;
FIG. 5 is an explanatory view of the procedure for manufacturing the oxide superconducting element according to the present invention;
FIG. 6 is a diagram showing the characteristics of the oxide superconducting element according to the present invention;
FIG. 7 is a diagram showing the temperature dependency of the electric resistibility when zinc is added to the oxide superconductor;
FIG. 8 is a diagram showing the typified structure of the oxide superconducting element;
FIG. 9 is a diagram showing the process of manufacturing the oxide superconducting element;
FIG. 10 is a diagram showing the electrical characteristics of the oxide superconducting element; and
FIG. 11 is a diagram showing the typified structure of the prior art oxide superconducting element.

### PREFERRED EMBODIMENT OF THE INVENTION

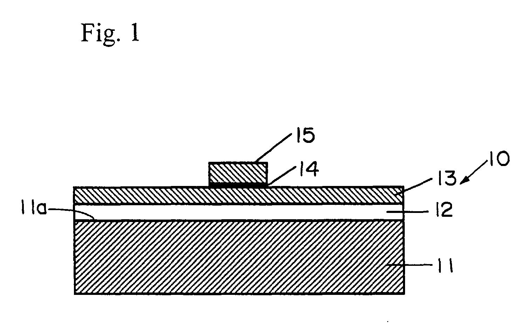

FIG. 1 is a typified diagram showing the structure of the superconducting element according to the present invention.

A superconducting element 10 includes an oxide superconducting single crystal or thick-film element 11 which also serves as a substrate, and a mechanical grinding process is performed to a surface 11a of the oxide superconducting single crystal or thick-film element 11, thereby forming a flattened surface.

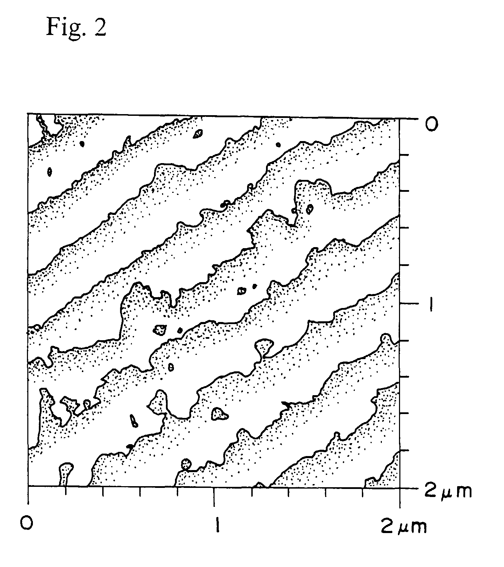

FIG. 2 is a typified diagram showing the image observed through an atomic force microscope (AFM) of the surface of a YBa₂Cu₃Oₓ oxide superconductor single crystal, which had been performed of the mechanical grinding process. The image shows that steps having a 1.2 nm height are clearly observed on the atomic surface, and that the surface is flat in an atomic size level.

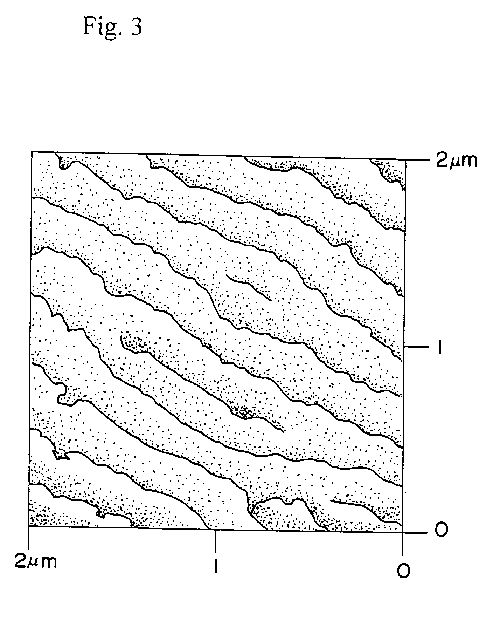

Similarly, FIG. 3 is a typified diagram showing the image observed through an atomic force microscope (AFM) of the surface of a YBa₂Cu₃Oₓ oxide superconductor thick-film, which had been performed of the mechanical grinding process. The image shows that steps are clearly observed on the atomic surface, and that the surface is flat in an atomic size level.

According to the present invention, an interlayer insulation layer 12 is laminated on the element 11 having a surface 11a flattened by a mechanical grinding process, and above the insulation layer 12 are laminated an oxide superconducting layer 13 constituting a lower electrode, a barrier layer 14, and an oxide superconducting layer 15 constituting an upper electrode, thereby forming the oxide superconducting element.

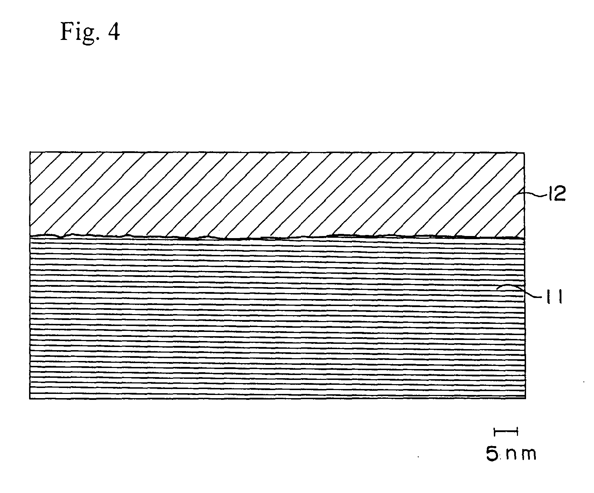

FIG. 4 is a typified diagram of a cross sectional transmission electron microscope (TEM) image observing the material formed by mechanically grinding the surface 11a of a YBa₂Cu₃Oₓ oxide superconductor single crystal 11, and depositing an insulator SrTiO₃ constituting a ground plane 12 on the surface 11a. FIG. 4 shows that an insulator 12 having a flatness in the atomic size level is laminated on a flat oxide superconductor 11.

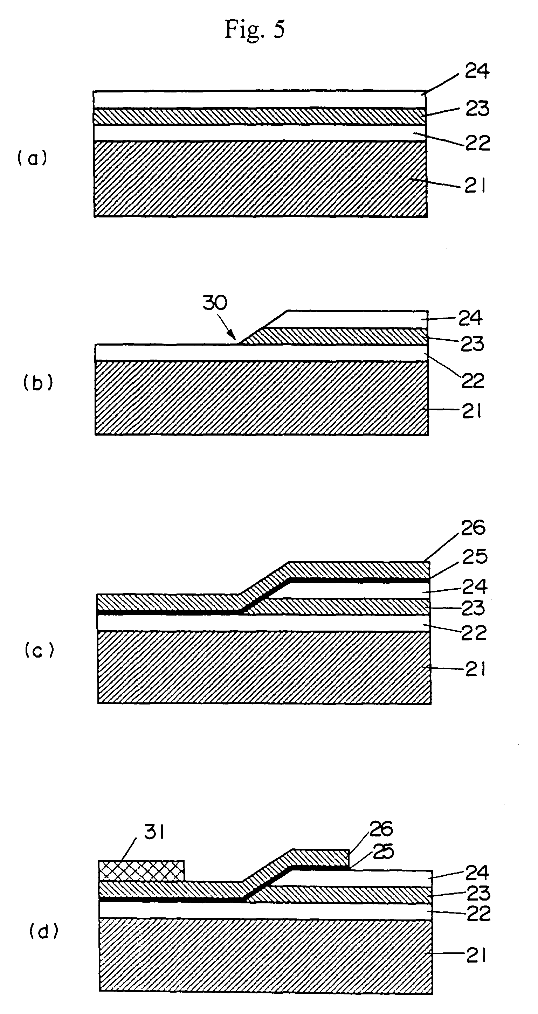

FIG. 5 explains the actual process for manufacturing the superconducting element according to the above-explained method.

At first, a (001) surface wafer is cut out from a Y-123 bulk single crystal grown by a crystal pulling method and having a diameter of 13 mm. Then, a mechanical grinding and cutting process is performed to the wafer, so as to form a substrate 21 having an 8 mm square size and a thickness of approximately 0.5 mm. Regular atomic steps having a height of approximately 1.2 nm are observed on the substrate surface through an atomic force microscope (AFM). It is confirmed that the substrate has a flatness in the level of a unit cell.

As shown in FIG. 5(a), a three layer film comprising an Sr₂AlTaO₆ (SAT) interlayer insulation layer 22, an Nd-123 superconducting layer 23, and an SAT insulation layer 24 each having a thickness of approximately 200 nm are formed successively on the whole surface of the substrate 21 by laser sputtering. A high-density sintered body of each material is used as a target, and a power density of the KrF pulse laser (wavelength: 248 nm) at the incidence window position of the vacuum device is set to approximately 2 J/cm². The oxygen gas pressure during deposition is 200 mTorr, and the substrate temperature is set to 750 °C. It is confirmed through an X-ray diffraction that each of the layers are c-axis oriented, and are epitaxially grown on a YBCO (001) surface.

The multilayer structure formed as above is processed by a standard photolithography and Ar ion milling process, so as to form a ramp structure 30 as shown in FIG. 5(b). The tilt angle of the ramp structure is approximately 10 degrees. Next, the structure is placed inside the laser sputtering chamber again, and as shown in FIG. 5(c), a barrier layer 25 formed of PrBa₂Cu₃Oy (pr-123) having a thickness of 7.5 nm and an Nd-123 superconducting layer 26 having a thickness of 250 nm are deposited successively. The deposition is performed under the same conditions as when depositing the lower Nd-123 layer.

Finally, as shown in FIG. 5(d), the Pr-123 / Nd-123 laminated layers are processed into an electrode structure by the photolithography and Ar ion milling process. Then, an Au pad 31 for the current terminal takeout is formed by a vacuum evaporation and lift off process, and thereby, the manufacturing of a ramp edge junction with a single crystal ground plane is completed. The width of the upper electrode pattern of the junction is set to 5 µm. Simultaneously, for comparison, a ramp edge junction is manufactured through similar processes with a c-axis-oriented YBCO thin-film having a thickness of 300 nm as the ground plane formed on an (La, Sr)₂AlTaO₆ (LSAT) (100) single crystal substrate by a laser sputtering method.

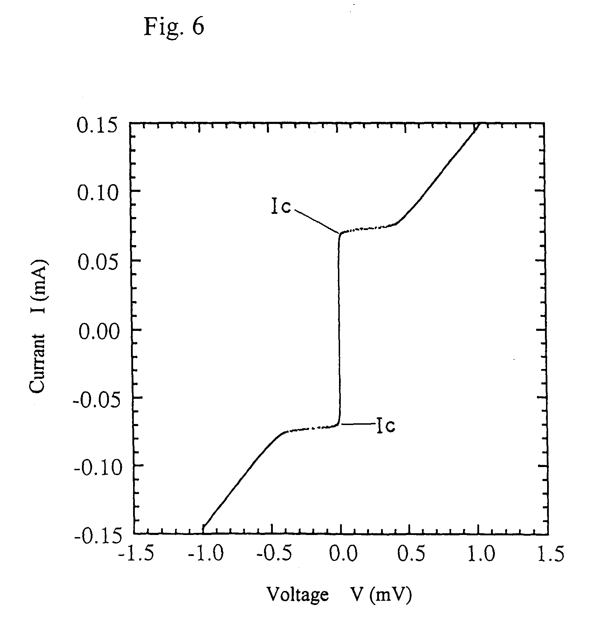

The current-voltage (I-V) characteristics of a ramp edge junction manufactured as above is measured under low temperature. FIG. 6 shows the I-V characteristics of the junction formed on the single crystal ground plane at 12K, which is confirmed to correspond to the characteristics of a typical weak-link Josephson junction shown by a resistively shunted junction (RSJ) model. The product of the Josephson critical current Ic and the junction resistance Rn is approximately 0.6 mV.

Next, Ic values of all 24 ramp edge junctions having the same shape existing on the same crystal substrate is measured and the dispersion of the values is evaluated. As a result, a standard deviation σ is calculated to be 15 %. On the other hand, the ramp edge junction formed on the thin film ground plane similarly showed an RSI-like I-V characteristics, but the average value of the Ic of the 24 junctions formed on one substrate is approximately 60 % higher than the average of the junctions formed on the single crystal substrate, and the standard deviation of the Ic is 26%, which is much higher than the value regarding the junctions on the single crystal substrate.

The ground plane may also be formed by implanting an element which destroys the superconductivity from the flattened surface, and thereby forming an insulation layer in the superconducting layer. A report discloses forming an ordinary-conducting layer in the superconducting layer by the above method (IEEE Trans. on Appl. Supercond. 7,2134 (1997)). According to the present invention, an iron-family ion is implanted, thereby gaining an insulation layer with a resistibility of over 100000 ohm·cm.

In order to manufacture a barrier layer having the same crystal structure as the oxide superconductor, one method involves adjusting the carrier quantity of the oxide superconductor YBa₂Cu₃Ox so as to reduce the superconductivity transition temperature, and to form an ordinary-conductor or a semiconductor as a result (J. Phys. Condens. Matter 8,8889 (1996)).

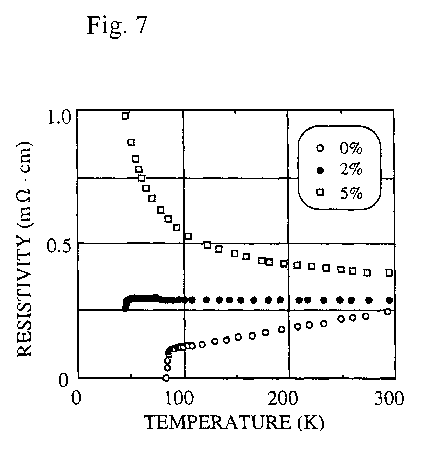

FIG. 7 shows the temperature dependency of the electric resistibility when Zn is added to the oxide superconductor YBa₂Cu₃Ox. It shows that addition of 5 % or more Zn brings out a semiconductor-like action. Such substance may be formed on the YBa₂Cu₃Ox thick film as the barrier layer, thereby forming a Josephson junction of YBa₂Cu₃Ox / YBa₂Cu₃Ox : Zn / YBa₂Cu₃Ox.

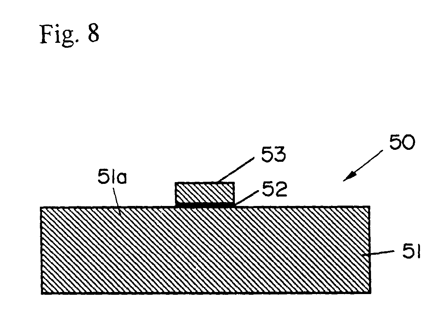

FIG. 8 is a typified diagram of the structure of the oxide superconducting element formed by applying the above-mentioned idea.

An oxide superconducting element 50 comprises an oxide superconducting single crystal or thick-film element 51, and the surface 51a of said element 51 is flattened by a mechanical grinding process.

Then, a barrier layer 52 is formed on the flattened surface 51a according to the above-mentioned method, and on the barrier layer 52 is deposited an oxide superconducting layer 53 which constitutes an upper electrode.

The oxide superconducting single crystal or thick-film element 51 constitutes the lower electrode, and the barrier layer is also formed out of the same substance. Accordingly, the manufacturing process may be simplified, and the cost of producing the oxide superconducting element may be reduced.

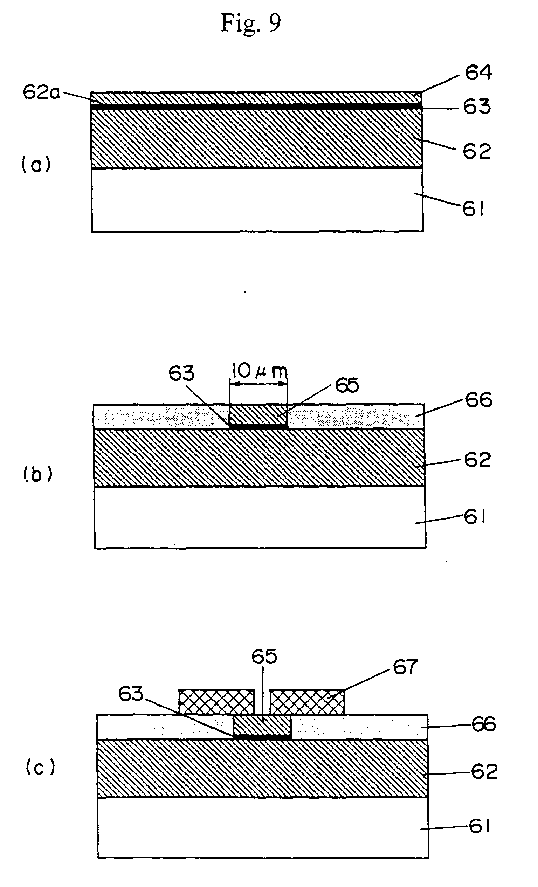

Next, FIG. 9 is referred to in explaining the manufacturing process of the element using the above-mentioned idea.

First, an MgO (100) single crystal substrate 61 is manufactured by an LPE method. Next, the surface 62a of a YBCO thick-film 62 having a thickness of approximately 120 µm formed on the substrate 61 is mechanically ground, and a thick-film having a unit cell level flatness is obtained. Next, by an MOCVD method, a barrier layer 63 formed of YBa₂(Cu_{0.97}Zn_{0.03})₃Oy having a thickness of 10 nm, and a YBCO layer 64 having a thickness of 60 nm are successively deposited on the thick-film 62, as shown in FIG. 9(a). As the MO material, Y(DPM)₃, Ba(DPM)₂-2 Pentaen, Cu(DPM)₂, and Zn(DPM)₂ are used, wherein the material is evaporated by a temperature of 70 - 140 °C, and the material is transferred to a reactor using Ar as a carrier gas. The total gas pressure is 10 Torr and the oxygen partial pressure is 0.6 Torr, and the susceptor temperature is 800 °C.

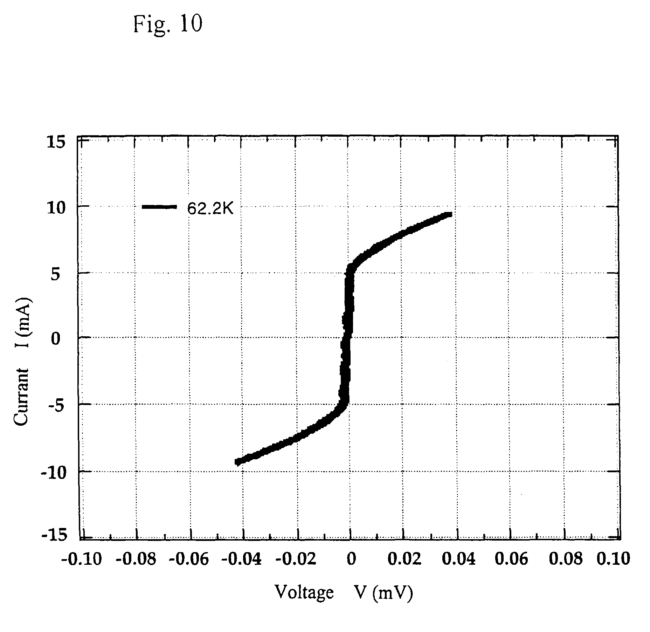

The laminated film formed as above is processed by a photolithography and ion-milling process, so as to form a 10 µm square sized mesa structure 65 as shown in FIG. 9(b). A CeO₂ insulation layer 66 is deposited so as to be self-aligned through sputtering under room temperature. Finally, an Au pad 67 made of Au for current terminal takeout is formed through a vacuum deposition and ion-milling process. Thereby, the manufacturing of a laminated junction structure is completed. The I-V characteristics of this junction is measured under low temperature, and the Y-Ba-Cu-Zn-O of the barrier layer showed a superconductivity transition at 50 K. In the temperature region between Tc = 80 K of the upper electrode YBCO layer and 50 K, an I-V characteristics of a typical SNS junction is observed as shown in FIG. 10. The I-V characteristics of the 24 junctions on the same substrate having the same areas are measured at a temperature of 60 K, and an Ic dispersion σ of 12 % is gained.

As explained above, according to the present invention, a laminated structure having an atomic-size flatness may be formed, and a Josephson junction having high reliability may be manufactured with good repeatability. Moreover, by forming a ground plane, the standard deviation σ showing the dispersion in the Josephson junction characteristics is 15 %, which is greatly improved from the standard deviation σ of the conventional Josephson junction which is over 20 %. Even further, the circuit design may be advantageously simplified, since the inductance of the element may be reduced.

## Claims

1. An oxide superconducting element formed by laminating an oxide superconductor constituting a lower electrode under a barrier layer (14) and an upper electrode over said barrier layer (14), wherein said lower electrode is formed of an oxide superconducting single crystal or thick film (11).

2. An oxide superconducting element formed by laminating an oxide superconductor constituting a lower electrode under a barrier layer (14) and an upper electrode over said barrier layer (14), wherein a ground plane formed of an oxide superconducting single crystal or thick-film (11) is placed under said lower electrode with an interlayer insulation layer (12) mounted therebetween.

3. An oxide superconducting element formed by laminating an oxide superconductor constituting a lower electrode under a barrier layer (25) and an upper electrode over said barrier layer (25), wherein an interlayer insulation layer (22) is formed on the surface of an oxide superconducting single crystal or thick-film (21), said surface being flattened by a mechanical process without vitiating the superconductivity thereof, and on said insulation layer (22) is formed a Josephson junction, said Josephson junction being electrically connected to said flattened surface.

4. An oxide superconducting element formed by laminating an oxide superconductor constituting a lower electrode under a barrier layer (25) and an upper electrode over said barrier layer (25), wherein the surface of an oxide superconducting single crystal or thick-film (21) being flattened by a mechanical process without vitiating the superconductivity thereof serves as a superconducting electrode, thereby forming a Josephson junction.

5. An oxide superconducting element formed by laminating an oxide superconductor constituting a lower electrode under a barrier layer (52) and an upper electrode over said barrier layer (52), wherein the material of said oxide superconducting element is formed by implanting an element for destroying superconductivity from a surface of an oxide superconducting single crystal or thick-film (51), said surface being flattened by a mechanical process without vitiating the superconductivity thereof, thereby forming an insulation layer in said superconducting layer (53).

6. An oxide superconducting element formed by laminating an oxide superconductor constituting a lower electrode under a barrier layer (52) and an upper electrode over said barrier layer (52), wherein:
the material of said oxide superconducting element is formed by implanting an element for destroying superconductivity from a surface of an oxide superconducting single crystal or thick-film (51), said surface being flattened by a mechanical process without vitiating the superconductivity thereof, thereby forming an insulation layer in said superconducting layer (53); and
said material serves as a superconducting electrode, thereby forming a Josephson junction.

7. An oxide superconducting element formed by laminating an oxide superconductor constituting a lower electrode under a barrier layer (63) and an upper electrode over said barrier layer (63), wherein:
the surface of an oxide superconducting single crystal or thick-film (62) being flattened by a mechanical process without vitiating the superconductivity thereof serves as a superconducting electrode, thereby forming a Josephson junction;
said upper electrode of said Josephson junction is made from the same substance as said flattened superconducting lower electrode; and
said barrier layer (63) is formed of a substance made by adding a microelement to said flattened superconducting substrate and thereby either creating a substance having a lowered superconducting transition temperature or creating an ordinary conducting substance.

8. An oxide superconducting element formed by laminating an oxide superconductor constituting a lower electrode under a barrier layer (63) and an upper electrode over said barrier layer (63), wherein:
the material of said oxide superconducting element is formed by implanting an element for destroying superconductivity from a surface of an oxide superconducting single crystal or thick-film, said surface being flattened by a mechanical process without vitiating the superconductivity thereof, thereby forming an insulation layer (66), in said superconducting layer;
said material serves as a superconducting electrode, thereby forming a Josephson junction, said upper electrode of said Josephson junction being made from the same substance as said flattened superconducting lower electrode; and
said barrier layer (63) is formed of a substance made by adding a microelement to said flattened superconducting substrate and thereby either creating a substance having a lowered superconducting transition temperature or creating an ordinary conducting substance.

9. An oxide superconducting material and element according to claims 1 through 8, wherein said thick-film substrate (61) is MgO.

10. An oxide superconducting material and element according to claims 1 through 8, wherein said oxide superconductor is REBa₂Cu₃Ox (RE = Y, Nd, Sm, Eu, Gd, Dy, Ho, Er, Tm, Yb, Lu or mixed crystals thereof).

11. An oxide superconducting material and element according to claims 1 through 8, wherein the method for manufacturing said thick-film (11, 21, 62) is a liquid phase epitaxial method.
